Europäisches Patentamt

European Patent Office

Office européen des brevets

(11) Publication number: **0 427 187 A2**

## EUROPEAN PATENT APPLICATION

(21) Application number: 90121181.3

(51) Int. Cl.5: **H01L 29/812**

(22) Date of filing: 06.11.90

(30) Priority: 06.11.89 JP 288160/89

(43) Date of publication of application:
15.05.91 Bulletin 91/20

(84) Designated Contracting States:
DE FR GB NL

(71) Applicant: SUMITOMO ELECTRIC INDUSTRIES,
LTD.
5-33, Kitahama 4-chome, Chuo-ku
Osaka-shi, Osaka 541(JP)

(72) Inventor: Shiga, Nobuo, c/o Yokohama Works
of Sumitomo Elec.
Industries, Ltd., 1, Taya-cho, Sakae-ku
Yokohama-shi, Kanagawa(JP)

(74) Representative: Kahler, Kurt, Dipl.-Ing.
Postfach 1249 Gerberstrasse 3
W-8948 Mindelheim(DE)

(54) Microwave semiconductor device.

(57) A microwave semiconductor device comprises a plurality of active regions of Schottky barrier FET arranged on a single semiconductor substrate (11) in a common gate width direction, and gate electrodes (12) are linearly connected to each other. Side-gate electrodes (15) each formed by an ohmic metal are arranged on the semiconductor substrate (11) between adjacent active regions (11B). In this portion, a gate wiring layer (12B) is arranged so as to cross over each side-gate electrode (15). With this arrangement, a sufficient side gate effect on the entire FET having gate electrodes (12) connected to have a large length, can be obtained, and a threshold voltage can be controlled after manufacturing.

**Fig.3A**

## MICROWAVE SEMICONDUCTOR DEVICE

### BACKGROUND OF THE INVENTION:

(Field of the Invention)

The present invention relates to a semiconductor device operated in a microwave band and, more particularly, to a semiconductor device formed by a Schottky barrier field effect transistor (FET).

(Description of the Related Art)

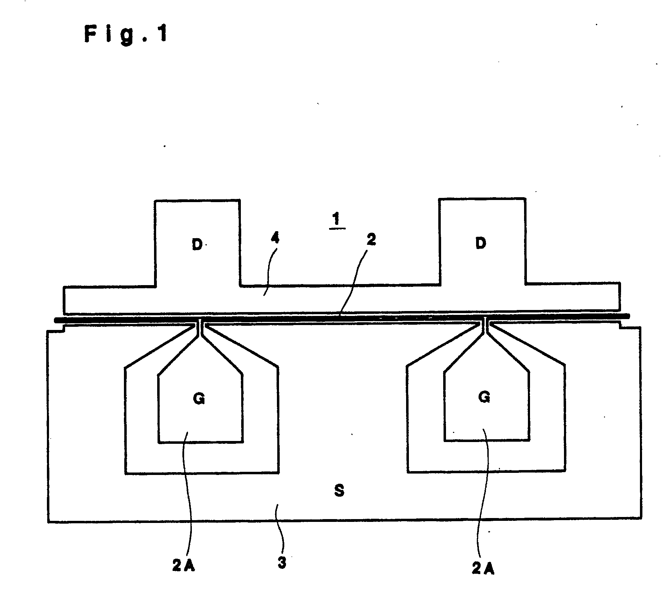

Fig. 1 shows an example of a conventionally used FET of this type.

A gate electrode 2 of an FET formed on a semiconductor substrate 1 has a very wide gate width so that the FET is appropriately operated in a microwave band. Two input signal supplying pads 2A for receiving a common input signal are arranged at the gate electrode 2. These are arranged in a $\pi$-shape as a whole. As described above, a plurality of pads (two here) are arranged since it is effective to decrease noise by reducing a gate resistance. For example, an FET having a gate width of 300 $\mu$m is used as a so-called X-band or KU-band FET. Note that reference numeral 3 denotes a source electrode wiring layer, and reference numeral 4 denotes a drain electrode wiring layer.

In the conventional microwave FET, the productive yield is decreased by a fluctuation in threshold voltage, resulting in inconvenience. Generally, the threshold voltage of the FET is determined by a thickness of an active layer or a carrier density. Manufacturing fluctuations of them cannot be inevitably prevented. Particularly, the FET for microwave has larger fluctuations because a microwave FET has a recess structure formed by etching a portion under the gate electrode. Accordingly, its threshold voltage often falls outside the range of design values.

If the threshold voltage can be controlled after a process is finished, this problem can be solved. In a normal FET having a narrow gate width, a side gate formed by an ohmic electrode is arranged on a semiconductor substrate near an active gate layer at a substrate portion extended in a gate width direction, and a threshold value can be controlled by a voltage applied to the side-gate electrode formed by the ohmic metal. As described above, in the microwave FET having a wide gate width, however, this method is not effective.

### SUMMARY OF THE INVENTION:

It is an object of the present invention to provide a microwave semiconductor device capable of controlling a threshold voltage after manufacturing.

In order to achieve the above object, in the microwave semiconductor device according to the present invention, a plurality of active regions of Schottky barrier FETs are arranged on a single semiconductor substrate in a common gate width direction, and gate electrodes of the active regions are linearly connected to each other. Side-gate electrodes each formed by an ohmic metal are arranged on the semiconductor substrate between the adjacent active regions. In this portion, gate wiring layers cross above the side-gate electrodes to form two-level crossings.

A sufficient side gate effect on the entire FET having gate electrodes connected to each other to have a large length can be obtained by a plurality of side-gate electrodes arranged on the semiconductor substrate between the adjacent active regions. In this portion, the gate wiring layers for connecting gate electrodes are connected linearly (when viewed from the top), passing above the side-gate electrodes.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

### BRIEF DESCRIPTION OF THE DRAWINGS:

Fig. 1 is a schematic plan view showing a conventional example;
Fig. 2 is a schematic plan view showing an embodiment of the present invention;
Fig. 3A is a plan view showing a side gate section in Fig. 2 in detail;
Fig. 3B is a sectional view of Fig. 3A;
Fig. 4 is a plan view showing a side gate section of a modification of the present invention; and

Fig. 5 is a plan view showing a side gate section of another modification.

## DETAILED DESCRIPTION OF THE PREFERRED EMBODIMENT:

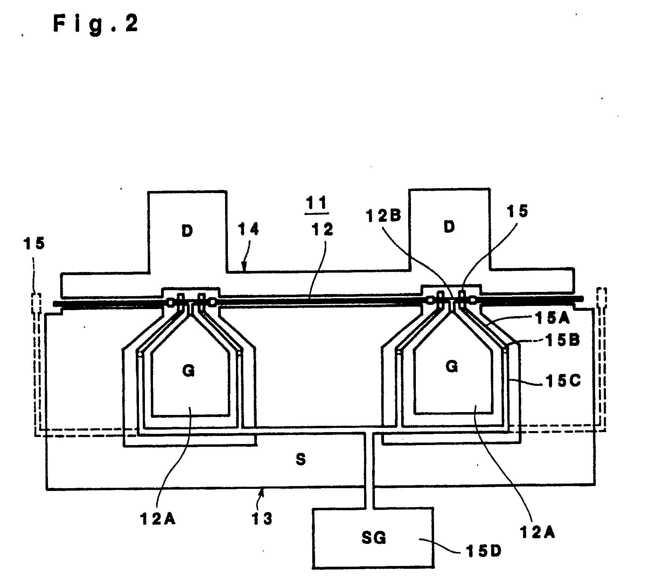

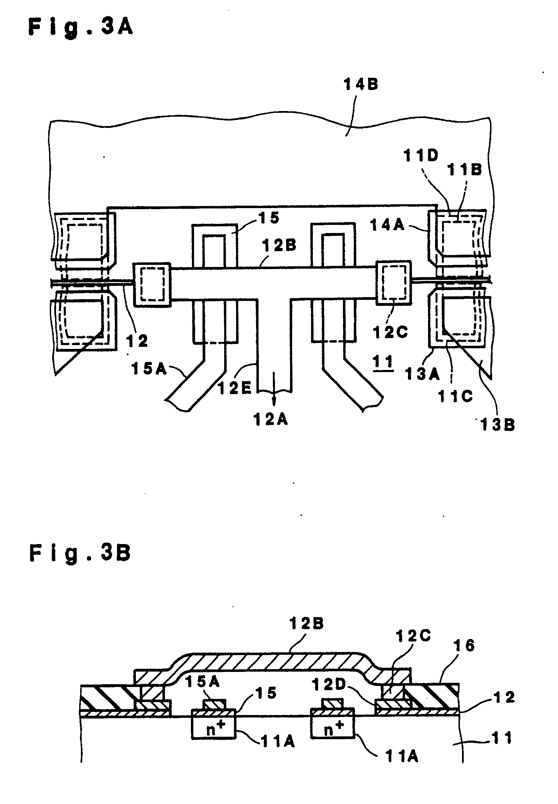

An embodiment of the present invention will be described hereinafter with reference to Figs. 2, 3A and 3B. In the drawings, the same reference numerals denote the same elements, and a repetitive description thereof will be omitted.

Fig. 2 is a view schematically showing a planar positional relationship of each pattern. Insulating interlayers and the like are omitted. Gate electrodes 12, a source electrode wiring layer 13, and a drain electrode wiring layer 14 are formed on a semi-insulating semiconductor (GaAs) substrate 11. The gate electrodes 12 adjacent to each other are commonly sconnected to input signal supplying pads 12A to form a $\pi$-shape as in the conventional FET shown in Fig. 1.

In this embodiment, in each portion where each gate electrode 12 is connected to the corresponding input signal supply pad 12A, a side-gate electrode 15 is formed on the semiconductor substrate between the adjacent active regions 11B.

Each side-gate electrode 15, as shown in Figs. 3A and 38 in detail, is formed by a side gate metal ohmic-contacting an $n^{+}$ region 11A, and extends in a direction perpendicular to a gate width direction. In this portion, the gate electrodes 12 are connected by a wiring layer 12B formed so as to cross above the side-gate electrodes 15. The linearly connected arrangement in the gate width direction is obtained.

In the portion where the gate wiring layer 12B crosses the side-gate electrodes 15, they may be electrically insulated from each other by an insulating interlayer 16. In this embodiment, however, the insulation is performed by an air-bridge arrangement which cause a reduction of a gate capacitance. The air-bridge arrangement is formed as follows. After the side-gate electrodes 15 are formed, this portion is covered by an organic film. After the gate wiring layer 12B is formed, the organic film is decomposed and removed to obtain the bridge structure of the gate wiring layer 12B over the side-gate electrodes 15. The gate wiring layer 12B in this portion is formed by an upper wiring layer, is connected to the gate electrodes 12 through contact hole portions 12C and lower wiring layers 12D, and is also connected to the input signal supplying pad 12A through an upper wiring layer 12E.

Each gate electrode 12 forms a Schottky junction with respect to an active region 11B shown by a broken line. Source and drain electrodes 13A and 14A respectively ohmic-contact $n^{+}$ regions 11C and 11D, and are commonly connected to wiring layers 13B and 14B. These source and drain wiring layers 13B and 14B are formed by lower wiring layers.

On the other hand, the side-gate electrodes 15 are connected to a lower wiring layer 15A, and are connected to an upper wiring layer 15C through contact hole portions 15B midway along a peripheral portion of the input signal supplying pad 12A connected to the gate electrodes 12, as shown in Fig. 2.

After the process is completed, a threshold voltage of the FET is changed in accordance with a magnitude of a side gate voltage by applying a voltage (side gate voltage) to a control pad 15D. To sufficiently obtain this side gate effect, it is preferable that the gap between each side-gate electrode 15 and the corresponding active region 1lb is about 5 to 10 $\mu$m.

As a side gate metal, e.g, Ni/AuGe or the like can be used.

As described above, according to the present invention, side gates are arranged on the semiconductor substrate between adjacent active regions, and gate wiring layers are formed so as to cross above the side-gate electrodes. As a result, even in a microwave FET wherein the gate electrodes are connected to have a large length in the gate width direction, a threshold voltage can be externally and electrically controlled after the end of process, resulting in an increase in effective yield.

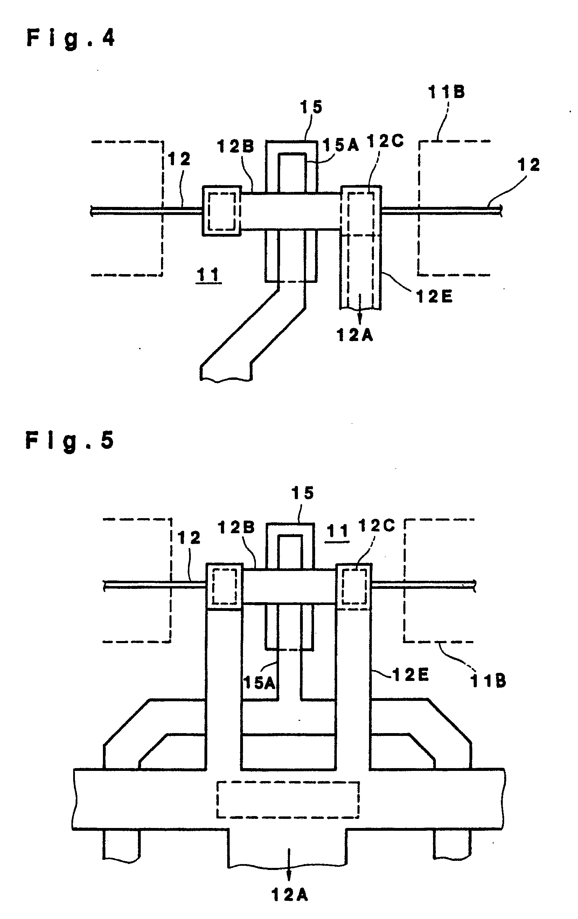

Note that patterns of electrodes and wiring layers are not limited to the above-described embodiment. For example, the gate electrodes are not limited to have a $\pi$-shape, but a T-shape having a smaller number of input signal supplying points by one. Alternatively, the number of input signal supplying points may be three or more. In addition, an arrangement of the side-gate electrodes 15 and a way of connecting each gate electrode may be variously modified. Fig. 4 shows its modification. With this arrangement, one side-gate electrode 15 is arranged between adjacent gate portions (active regions 11B). In this modification, the input signal supplying pad 12A is connected from a connecting point between a gate wiring layer 12B crossing above a side-gate electrode 15 and a right gate electrode 12. As shown in Fig. 5, wiring layers can be symmetrically extracted from both connecting points to the input signal supplying pad 12A. Moreover, it is obvious that the side-gate electrodes 15 may be arranged on an extension in the gate width direction as shown by a broken line in Fig. 2.

From the invention thus described, it will be obvious that the invention may be varied in many ways. Such variations are not to be regarded as a departure from the spirit and scope of the invention, and all such modifications as would be obvious to one skilled in the art are intended to be included within the scope of the following claims.

## Claims

1. A microwave semiconductor device comprising a plurality of active regions (11B) of Schottky barrier YET arranged on a single semiconductor substrate (11) in a common gate width direction, and gate electrodes (12) linearly connected to each other, wherein at least one side-gate electrode (15) formed by an ohmic metal is arranged at a portion of said microwave semiconductor substrate (11) between adjacent active regions (11b), and a gate wiring layer (12B) is arranged so as to cross above said side-gate electrode (15) at said portion.

2. The microwave semiconductor device according to claim 1, wherein at least two side-gate electrodes (15) are provided for each of said portion.

3. The microwave semiconductor device according to claim 1 or 2, wherein said side-gate electrodes (15) are connected to a control pad (15D) for applying a side-gate voltage for changing the threshold voltage of said FET in accordance with the magnitude of said side-gate voltage.

4. The microwave semiconductor device according to claim 1, 2, or 3, wherein said gate wiring layer (12B) is electrically insulated from said side-gate electrode(s) (15) by an interlayer (16).

5. The microwave semiconductor device according to claim 1, 2, or 3, wherein said gate wiring layer (12B) is electrically insulated from said side-gate electrode(s) (15) by air.

6. The microwave semiconductor device according to any preceding claim, wherein the side-gate electrodes (15) are arranged on lateral extensions in the gate width direction.

# Fig.1

# Fig.2

**Fig.3A**

**Fig.3B**

**Fig.4**

15
12B 15A 12C 11B
12
11
12E
12A
12

**Fig.5**

15
12B 11 12C
12
15A
12E 11B
12A